(19) Europäisches Patentamt
European Patent Office
Office européen des brevets

(11) **EP 3 853 994 B1**

(12) **FASCICULE DE BREVET EUROPEEN**

(45) Date de publication et mention de la délivrance du brevet:
**20.08.2025 Bulletin 2025/34**

(21) Numéro de dépôt: **19766034.3**

(22) Date de dépôt: **13.09.2019**

(51) Classification Internationale des Brevets (IPC):
**H02P 21/14** (2016.01)   **H02P 21/13** (2006.01)

(52) Classification Coopérative des Brevets (CPC):
**H02P 21/141;** H02P 21/13

(86) Numéro de dépôt international:
**PCT/EP2019/074552**

(87) Numéro de publication internationale:
**WO 2020/058131 (26.03.2020 Gazette 2020/13)**

(54) **PROCÉDÉ DE DÉTERMINATION DU FLUX MAGNÉTIQUE D'UNE MACHINE ÉLECTRIQUE**

VERFAHREN ZUR BESTIMMUNG DES MAGNETISCHEN DURCHFLUSSES EINER ELEKTROMASCHINE

METHOD FOR DETERMINING THE MAGNETIC FLUX OF AN ELECTRIC MACHINE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.09.2018 FR 1858548**

(43) Date de publication de la demande:
**28.07.2021 Bulletin 2021/30**

(73) Titulaire: **IFP Energies nouvelles**
**92852 Rueil-Malmaison (FR)**

(72) Inventeurs:
• **NGUYEN, Hoai-Nam**
**92852 RUEIL-MALMAISON CEDEX (FR)**
• **ZITO, Gianluca**
**92852 RUEIL-MALMAISON CEDEX (FR)**

(74) Mandataire: **IFP Energies nouvelles**
**Département Propriété Industrielle**
**Rond Point de l'échangeur de Solaize**
**BP3**
**69360 Solaize (FR)**

(56) Documents cités:
**EP-A1- 1 885 054**       **EP-A2- 2 582 036**
**FR-A1- 2 984 637**       **FR-A1- 3 035 755**
**US-A1- 2016 254 771**

• **KOTEICH MOHAMAD: "Flux estimation algorithms for electric drives: A comparative study", 2016 3RD INTERNATIONAL CONFERENCE ON RENEWABLE ENERGIES FOR DEVELOPING COUNTRIES (REDEC), IEEE, 13 July 2016 (2016-07-13), pages 1 - 6, XP032972837, DOI: 10.1109/REDEC.2016.7577558**

**Description**

La présente invention concerne le domaine du contrôle des machines électriques, en particulier le contrôle des machines électriques synchrones à pôles saillants. Ces machines électriques trouvent une application notamment dans le domaine des véhicules automobiles.

Classiquement, une machine électrique comprend un rotor (partie mobile) et un stator (partie fixe). Le rotor est habituellement logé à l'intérieur du stator. Généralement, le stator est de forme annulaire et est logé à l'intérieur d'un support tubulaire pour y être fixé.

Le stator comprend des générateurs de flux magnétique, généralement des bobinages électriques. Ces bobinages sont alimentés par une pluralité (classiquement trois) phases électriques, afin de générer un champ magnétique tournant. De plus, selon le type de machine électrique, notamment pour les machines électriques synchrones à pôles saillants, le rotor peut comprendre des aimants permanents.

Lors du fonctionnement d'une telle machine électrique, les bobinages sont parcourus par un courant électrique pour générer le champ magnétique nécessaire à l'entraînement en rotation du rotor.

Il existe plusieurs types de contrôle de telles machines électriques, tels que divulgués dans les documents US 2016/254771 A1, EP 2 582 036 A2 ou EP 1 885 054 A1. Il est connu notamment que la méthode de contrôle direct du couple (en anglais « direct torque control method ») est une des stratégies les plus performantes de contrôle, qui permet un contrôle du couple aussi bien en régime permanent qu'en régime transitoire, en particulier pour les machines électriques synchrones à pôles saillants. De plus, cette méthode de contrôle est plus facile à implémenter qu'une méthode de contrôle de champ orienté. En outre, cette méthode requiert moins d'informations relatives à la machine électrique, et aucune boucle de contrôle de courant n'est nécessaire, ce qui permet notamment de résoudre le problème de retard lié à cette boucle de contrôle de courant.

Toutefois, l'inconvénient de cette méthode de contrôle est qu'elle est basée sur le signal de flux magnétique de la machine électrique, alors que cette grandeur n'est pas directement mesurable lorsque la machine électrique est en fonctionnement. Le flux magnétique doit alors être estimé, par exemple au moyen d'un observateur qui utilise les autres grandeurs mesurables. Le document : Mohamad Koteich. 'Flux estimation algorithms for electric drives: a comparative study'. In: Renewable Energies for Developing Countries (REDEC), 2016 3rd International Conference on. IEEE. 2016, pp. 1-6 (cit. on p. 5) passe en revue un certain nombre de méthodes de détermination du flux magnétique.

La plupart des méthodes de l'art antérieur requièrent la connaissance de la résistance, du flux magnétique du rotor et de l'inductance. Toutefois, alors que la résistance de peut être considérée comme connue, la valeur exacte du flux magnétique du rotor reste inconnu, notamment car il dépend de la température du rotor, qui ne peut pas être mesuré directement. En outre, en présence de saturation magnétique l'inductance est une fonction non linéaire du courant. Par conséquent, le problème d'estimation du flux magnétique de la machine électrique est non trivial, ce qui entraîne de la complexité et/ou de l'imprécision dans l'estimation.

La demande de brevet FR 3035755 décrit une méthode de contrôle d'une machine électrique basée sur une estimation du flux magnétique obtenu par un observateur et par un algorithme de Kalman étendu discret. La modélisation utilisée dans cette méthode est peu robuste aux variations paramétriques, notamment car le flux magnétique est estimé indirectement, car il nécessite le calcul des courants. De plus, le modèle décrit dans cette demande de brevet ne prend pas en compte la non-linéarité des inductances (saturation magnétique). En outre, l'algorithme du Kalman étendu discret ne permet pas la variabilité dans le temps du système. En effet, le filtre de Kalman étendu prend en compte seulement la non-linéarité liée à la présence de la vitesse dans les équations.

Afin de pallier ces inconvénients, la présente invention concerne un procédé de détermination du flux magnétique d'une machine électrique, basé sur des mesures de courants et tensions dans les phases de la machine électrique, sur un modèle dynamique du flux magnétique, et sur un filtre de Kalman adaptatif. Le modèle dynamique du flux magnétique permet d'obtenir un modèle précis (prenant en compte la variabilité dans le temps du système) et robuste du flux magnétique. Ainsi, le flux magnétique est déterminé directement. Le filtre de Kalman adaptatif permet une adaptation de la matrice de covariance du bruit en fonction de la vitesse de rotation de la machine électrique. Ainsi, le filtre est performant sur une large gamme de fonctionnement de la machine électrique. En outre, le filtre de Kalman adaptatif est robuste vis-à-vis des variations du flux magnétique du rotor et de l'inductance.

L'invention concerne également un procédé et un système de contrôle d'une machine électrique mettant en œuvre le procédé de détermination du flux magnétique.

**Le procédé selon l'invention**

L'invention concerne un procédé de détermination du flux magnétique d'une machine électrique, ladite machine électrique comprenant un rotor, un stator, ledit stator comprenant des bobinages connectés à une pluralité de phases électriques. Pour ce procédé, on met en œuvre les étapes suivantes :

a) On mesure un courant et une tension dans lesdites phases de ladite machine électrique ;

b) On détermine la vitesse de rotation électrique dudit rotor, notamment en fonction de la vitesse de rotation mécanique dudit rotor ;

c) On construit un modèle dynamique dudit flux magnétique de ladite machine électrique, ledit modèle dynamique dudit flux magnétique reliant ledit flux magnétique au courant et à la tension des phases de la machine électrique, et à ladite vitesse de rotation électrique dudit rotor ; et

d) On détermine ledit flux magnétique φ en appliquant un filtre de Kalman adaptatif audit modèle dynamique de flux magnétique, ledit modèle dynamique de flux magnétique étant appliqué auxdites mesures de courant et de tension et à ladite vitesse de rotation électrique déterminée.

Selon un mode de réalisation, on détermine ladite vitesse de rotation électrique $\omega_e$ dudit rotor par une formule du type $\omega_e = p\omega$ avec p le nombre de paires de pôles de la machine électrique et $\omega$ la vitesse de rotation mécanique dudit rotor.

Avantageusement, on détermine ladite vitesse de rotation mécanique par une méthode de boucle à phase asservie PLL.

Conformément à une mise en œuvre, ledit modèle dynamique de flux magnétique (MOD) s'écrit

$$\begin{cases} \varphi_d(t) = L_d i_d(t) + \sqrt{\frac{3}{2}}\Phi, \\ \varphi_q(t) = \begin{cases} L_{qs}i_q(t) - b_{qs}, & \text{if } i_q(t) \leq -i_{qm}, \\ L_q i_q(t), & \text{if } -i_{qm} \leq i_q(t) \leq i_{qm}, \\ L_{qs}i_q(t) + b_{qs} & \text{if } i_{qm} \leq i_q(t) \end{cases} \end{cases}$$

avec φ le flux magnétique de la machine électrique, i le courant, Φ le flux du rotor, L les inductances de ladite machine électrique, $L_{qs}, b_{qs}$ des coefficients qui prennent en compte l'effet de saturation, d et q les axes dans le repère de Park, et $i_{qm}$ la valeur de courant de quadrature pour lequel le flux magnétique est une fonction linéaire du courant de quadrature.

On applique ledit filtre de Kalman adaptatif en mettant en œuvre les étapes suivantes :

i) On modifie ledit modèle dynamique de flux magnétique en intégrant des incertitudes dans ledit modèle et un bruit de mesure ;

ii) On discrétise ledit modèle dynamique de flux magnétique modifié ; et

iii) On applique un algorithme de filtre de Kalman adaptatif audit modèle modifié et discrétisé

On applique ledit algorithme de filtre de Kalman adaptatif en mettant en œuvre les étapes suivantes :

(1) On initialise k = 0, le vecteur d'état x̂(0) et l'état de la matrice de covariance, P(0|0) = $P_0$

(2) On applique les équations de mise à jour temporelle et de mise à jour de mesure pour obtenir x̂(k|k) et P(k|k) :

$$\begin{cases} \hat{x}(k|k-1) = A_d\hat{x}(k-1|k-1) + B_d u(k-1), \\ P(k|k-1) = A_d P(k-1|k-1)A_d^T + B_d Q_\epsilon B_d^T \end{cases}$$

$$\begin{cases} K(k) = P(k|k-1)\left(P(k|k-1) + R\right)^{-1} \\ \hat{x}(k|k) = \hat{x}(k|k-1) + K(k)\left(x(k) - \hat{x}(k|k-1)\right), \\ P(k|k) = (I - K(k))P(k|k-1) \end{cases}$$

(3) On détermine ledit flux magnétique φ estimé au temps k par les formules

$$\begin{cases} \hat{\varphi}_d(k) = \hat{x}_1(k|k), \\ \hat{\varphi}_q(k) = \hat{x}_2(k|k) \end{cases}$$

Avec k le temps discrétisé, A_d,B_d, des matrices de la réalisation d'état, P la matrice de covariance du vecteur d'état, R une matrice de calibration, K le gain du filtre de Kalman, Q_ε un paramètre d'ajustement..

De manière avantageuse, ladite machine électrique est une machine électrique synchrone à pôles saillants.

En outre, l'invention concerne un procédé de contrôle d'une machine électrique, mettant en œuvre les étapes suivantes :

a) On détermine un flux magnétique φ de ladite machine électrique au moyen du procédé de détermination dudit flux magnétique selon l'une des caractéristiques précédentes ; et

b) On contrôle (CON) ladite machine électrique au moyen dudit flux magnétique déterminé.

Avantageusement, on contrôle ladite machine électrique (CON) selon une méthode de contrôle direct du couple de la machine électrique mise en œuvre à partir dudit flux magnétique.

De plus, l'invention concerne un système de contrôle d'une machine électrique comprenant des moyens de contrôle pour mettre en œuvre le procédé de contrôle selon l'une des caractéristiques précédentes.

**Présentation succincte des figures**

D'autres caractéristiques et avantages du procédé selon l'invention, apparaîtront à la lecture de la description ci-après d'exemples non limitatifs de réalisations, en se référant aux figures annexées et décrites ci-après.

La figure 1 illustre les étapes du procédé selon un mode de réalisation de l'invention.
Les figures 2 et 3 représentent, les valeurs, dans le repère de Park, du flux magnétique de la machine électrique en fonction du courant.

**Description détaillée de l'invention**

La présente invention concerne un procédé de détermination, en temps réel, du flux magnétique d'une machine électrique. La machine électrique comprend un rotor et un stator, ce dernier étant équipé de bobinages connectés à plusieurs phases électriques, par exemple à trois phases électriques pour générer un champ magnétique permettant la rotation du rotor.

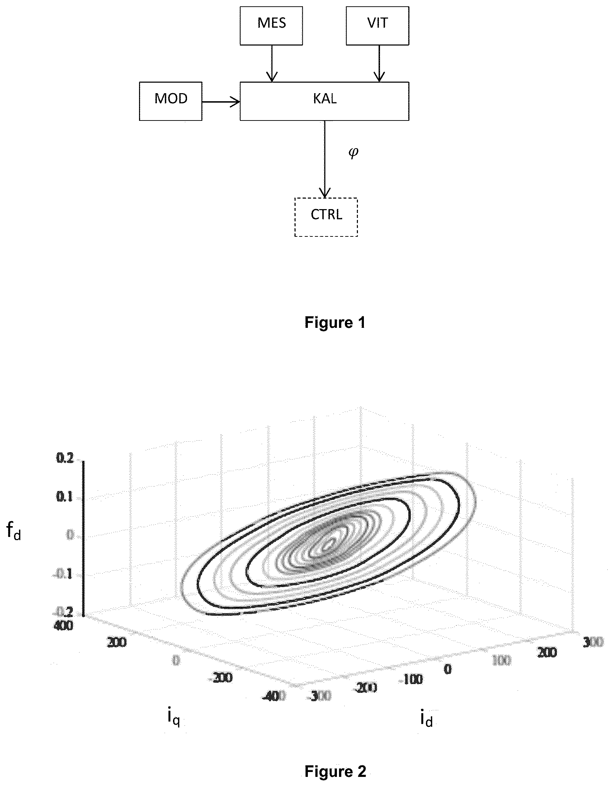

La figure 1 décrit, schématiquement et de manière non limitative, les étapes du procédé selon un mode de réalisation de l'invention. Le procédé de détermination du flux magnétique comprend les étapes suivantes :

1) Mesures des courants et des tensions (MES)
2) Détermination de la vitesse de rotation électrique (VIT)
3) Construction du modèle dynamique de flux magnétique (MOD)
4) Application du filtre de Kalman adaptatif (KAL)

Les étapes 1) à 3) sont indépendantes, et peuvent être réalisées dans cet ordre, dans un ordre différent ou simultanément.

L'étape 4) permet de déterminer le flux magnétique φ de la machine électrique.

En outre, l'invention concerne un procédé de contrôle d'une machine électrique. Un tel procédé de contrôle comporte les étapes 1 à 4) décrites ci-dessus et une étape 5) de contrôle de la machine électrique (CTRL).

Cette étape 5) de contrôle est une étape facultative. En effet, le flux magnétique peut être utilisé de manière différente, notamment pour un diagnostic de défaillance de la machine électrique.

Les étapes 1) à 5) seront détaillées dans la suite de la description.

Notations :

Au cours de la description, les notations suivantes seront utilisées :

$v$ : tensions aux bornes des phases de la machine électrique.

$i$ : courants circulant dans les phases de la machine électrique.

$i_{qm}$ : valeur de courant de quadrature pour lequel le flux magnétique est une fonction linéaire du courant de quadrature

$\omega$: vitesse de rotation mécanique du rotor, correspondant à la vitesse de rotation du rotor de la machine électrique par rapport au stator.

$\omega_e$ : vitesse de rotation électrique du rotor.

$\Phi$: intensité du flux magnétique de l'aimant du rotor, considéré pour le procédé selon l'invention, dans un cas nominal, pour une température de 20°C.

R(t) : résistance des bobines de la machine électrique, il s'agit d'un paramètre connu pouvant être obtenu expérimentalement.

$L_d$ : inductance directe de ladite machine électrique; il s'agit d'un paramètre de la machine électrique qui est connu (donnée constructeur ou obtenue expérimentalement).

$L_q$ : inductance en quadrature de ladite machine électrique; il s'agit d'un paramètre de la machine électrique qui est connu (donnée constructeur ou obtenue expérimentalement).

$L_{qs}$ : inductance qui prend en compte le phénomène de saturation (donnée constructeur ou obtenue expérimentalement).

$p$ : nombre de pairs de pôles de la machine électrique.

$\varphi$ : flux magnétique de la machine électrique.

A : matrice de la représentation d'état $A = \begin{pmatrix} 0 & \omega_e(t) \\ -\omega_e(t) & 0 \end{pmatrix}$.

B : matrice identité $B = \begin{pmatrix} 1 & 0 \\ 0 & 1 \end{pmatrix}$.

f : fonction de la représentation d'état.

$b_{qs}$ : coefficient scalaire, qui prend en compte le phénomène de saturation, cette valeur peut être obtenue expérimentalement.

u : vecteur des données de la représentation d'état.

$x = \begin{pmatrix} \varphi_d \\ \varphi_q \end{pmatrix}$ vecteur d'état de la représentation d'état, correspondant à l'état non mesurable.

$\varepsilon$ : les dynamiques non modélisées.

$\eta$ : bruits de mesure.

Ts : période d'échantillonnage.

k : temps discrétisé.

$A_d$ : matrice de la représentation d'état discrétisée.

$B_d$ : matrice de la représentation d'état discrétisée.

J : fonction de coût minimisée par le filtre de Kalman.

P : matrice de covariance du vecteur d'état.

P$_0$, Q, R : matrices de calibration.

$Q_\varepsilon$ : paramètre d'ajustement.

K : gain du filtre de Kalman.

Les valeurs estimées sont indiquées par un accent circonflexe. Les valeurs moyennes sont indiquées par une barre au-dessus de la variable. Les dérivées par rapport au temps sont indiquées par un point. Les notations indexées par la mention $_d$ (directe) ou $_q$ (quadrature) signifient que les grandeurs sont exprimées dans le repère de Park. En outre, les valeurs à l'état initial sont indiquées avec un 0 (t ou k = 0).

1) Mesure des courants et des tensions

Lors de cette étape, on mesure les courants et les tensions dans les phases de la machine électrique.
Ces mesures peuvent être réalisées par des capteurs de tension et de courant.

2) Détermination de la vitesse de rotation électrique du rotor

Il s'agit de déterminer la vitesse de rotation électrique du rotor.
Selon un mode de réalisation de l'invention, la vitesse de rotation électrique du rotor peut être déterminée à partir de la vitesse de rotation mécanique du rotor, au moyen de la formule : $\omega_e = p\omega$.
Conformément à une mise en œuvre de ce mode de réalisation, la vitesse de rotation mécanique du rotor peut être estimée, par toute méthode connue de l'homme du métier. Par exemple, la vitesse de rotation mécanique peut être estimée à partir d'une méthode de type boucle à phase asservie PLL (de l'anglais « phase-locked loop »). En variante, la méthode d'estimation de la vitesse de rotation mécanique peut être conforme à celle décrite dans la demande de brevet FR 2 984 637.
Alternativement, la vitesse de rotation mécanique du rotor peut être mesurée au moyen d'un capteur de vitesse placé sur la machine électrique.
En variante, la vitesse de rotation électrique peut être déterminée directement.

3) Construction du modèle dynamique du flux magnétique

Lors de cette étape, on construit un modèle dynamique du flux magnétique. Le modèle dynamique du flux magnétique relie le flux magnétique au courant, à la tension dans les phases électriques de la machine électrique et à la vitesse de rotation électrique du rotor. Le modèle est dit dynamique car il est fonction de la vitesse de rotation.
Le modèle dynamique du flux magnétique est une représentation d'état de la machine électrique. On rappelle qu'en théorie des systèmes (et en automatique), une représentation d'état permet de modéliser un système dynamique sous une forme matricielle, en utilisant des variables d'état. Cette représentation peut être linéaire ou non, continue ou discrète. La représentation permet de déterminer l'état interne et les sorties du système à n'importe quel instant futur si l'on connaît l'état à l'instant initial et le comportement des variables d'entrée qui influent sur le système.
Dans le repère de Park (d, q), le modèle dynamique du flux magnétique peut être exprimé par les équations différentielles suivantes :

$$\begin{cases} \dot{\varphi}_d(t) = -R(t)i_d(t) + \omega_e(t)\varphi_q(t) + v_d(t), \\ \dot{\varphi}_q(t) = -R(t)i_q(t) - \omega_e(t)\varphi_d(t) + v_q(t) \end{cases}$$

En écrivant ces équations différentielles, sous forme vectorielle, on obtient :

$$\begin{bmatrix} \dot{\varphi}_d(t) \\ \dot{\varphi}_q(t) \end{bmatrix} = \begin{bmatrix} 0 & \omega_e(t) \\ -\omega_e(t) & 0 \end{bmatrix} \begin{bmatrix} \varphi_d(t) \\ \varphi_q(t) \end{bmatrix} + \begin{bmatrix} v_d(t) - R(t)i_d(t) \\ v_q(t) - R(t)i_q(t) \end{bmatrix}$$

Ou de manière équivalente :

$$\dot{x}(t) = A(t)x(t) + Bu(t)$$

avec $x(t) = \begin{bmatrix} \varphi_d(t) \\ \varphi_q(t) \end{bmatrix}$ l'état non mesurable, et $u(t) = \begin{bmatrix} v_d(t) - R(t)i_d(t) \\ v_q(t) - R(t)i_q(t) \end{bmatrix}$ l'entrée du modèle.

D'après cette équation, il est clair que l'équation d'état du flux magnétique de la machine électrique peut être décrit par un modèle linéaire dans le temps. Toutefois, l'équation de l'état du flux magnétique de la machine électrique est une fonction hautement non linéaire des courants $i_d$ et $i_q$ et du flux magnétique du rotor $\Phi$. On peut écrire alors :

$$\begin{cases} \varphi_d(t) = f_d(i_q(t), i_q(t)) + \sqrt{\tfrac{3}{2}}\Phi(t) \\ \varphi_q(t) = f_q(i_q(t), i_q(t)) \end{cases}$$

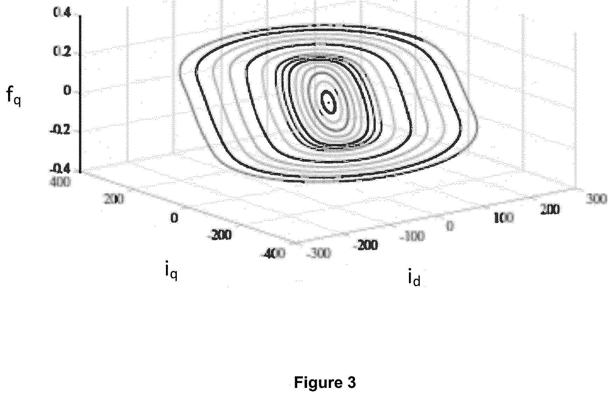

Les figures 2 et 3 représentent des exemples de fonctions $f_d$ et $f_q$ en fonction des courants $i_d$ et $i_q$ pour une application donnée. Il peut être observé que, alors que la fonction $f_d$ est une fonction relativement linéaire par rapport à $i_d$, ce n'est pas le cas pour la fonction $f_q$. Ainsi, le problème d'estimation du flux magnétique de la machine électrique devient plus complexe, d'autant plus que les fonctions $f_d$ et $f_q$ sont également fonction de l'angle mécanique du rotor.

Une solution à ce problème complexe pourrait être de réaliser les cartographies des grandeurs de flux magnétiques $\varphi_d$ et $\varphi_q$. Cette solution requiert une mémoire importante et un nombre important de mesures expérimentales. En outre, le flux magnétique du rotor varie en fonction de la température. C'est pourquoi le modèle décrit ci-dessus est complexe à mettre en œuvre.

Selon un mode de réalisation de l'invention, on peut construire un modèle dynamique du flux magnétique simple à mettre en œuvre tout en conservant sa précision, le modèle simplifié pouvant être défini par les équations suivantes :

$$\begin{cases} \varphi_d(t) = L_d i_d(t) + \sqrt{\tfrac{3}{2}}\Phi, \\ \varphi_q(t) = \begin{cases} L_{qs}i_q(t) - b_{qs}, & \text{if } i_q(t) \leq -i_{qm}, \\ L_q i_q(t), & \text{if } -i_{qm} \leq i_q(t) \leq i_{qm}, \\ L_{qs}i_q(t) + b_{qs} & \text{if } i_{qm} \leq i_q(t) \end{cases} \end{cases}$$

Ce modèle présente l'avantage d'être précis et peu coûteux en mémoire et en temps de calcul, ce qui facilite son implémentation dans un filtre de Kalman adaptatif, et, le cas échéant, au sein d'un procédé de contrôle de la machine électrique.

Conformément à une mise en œuvre de ce mode de réalisation, on peut considérer le flux magnétique du rotor $\Phi$ dans un cas nominal, pour lequel une température de 20 °C est considérée.

Pour ce mode de réalisation, on peut écrire l'équation d'état de la manière suivante :

$$\dot{x}(t) = A(t)x(t) + Bu(t)$$

$$x(t) = \begin{bmatrix} L_d i_d(t) + \sqrt{\tfrac{3}{2}}\Phi \\ f(i_d(t)) \end{bmatrix}$$

avec

$$f(i_d(t)) = \begin{cases} L_{qs}i_q(t) - b_{qs}, & \text{if } i_q(t) \leq -i_{qm}, \\ L_q i_q(t), & \text{if } -i_{qm} \leq i_q(t) \leq i_{qm}, \\ L_{qs}i_q(t) + b_{qs} & \text{if } i_{qm} \leq i_q(t) \end{cases}$$

4) Application du filtre de Kalman adaptatif

Lors de cette étape, on détermine le flux magnétique de la machine électrique. Pour cela, on applique un filtre de Kalman adaptatif au modèle dynamique construit à l'étape 3), appliqué aux mesures de tensions et de courants obtenues à l'étape 1), et à la vitesse de rotation électrique du rotor obtenue à l'étape 2). L'application du filtre de Kalman permet d'obtenir un observateur d'état. Le filtre de Kalman adaptatif permet une adaptation de la matrice de covariance du bruit en fonction de la vitesse de rotation de la machine électrique. Ainsi, le filtre est performant sur une large gamme de fonctionnement de la machine électrique. En outre, le filtre de Kalman adaptatif est robuste vis-à-vis des variations du flux magnétique du rotor et de l'inductance.

On rappelle qu'un observateur d'état, ou un estimateur d'état, est, en automatique et en théorie des systèmes, une extension d'un modèle représenté sous forme de représentation d'état. Lorsque l'état du système n'est pas mesurable, on construit un observateur qui permet de reconstruire l'état à partir d'un modèle.

Selon un mode de réalisation de l'invention, on peut appliquer le filtre de Kalman adaptatif en mettant en œuvre les étapes suivantes :

- On modifie le modèle dynamique de flux magnétique en intégrant des dynamiques non modélisées et un bruit de mesure,
- On discrétise le modèle dynamique du flux magnétique modifié, et
- On applique un algorithme de filtre de Kalman adaptatif au modèle dynamique modifié et discrétisé.

Conformément à un exemple de ce mode de réalisation, on peut mettre en œuvre les différentes étapes décrites ci-dessous.

On modifie le modèle dynamique du flux magnétique de manière à prendre en compte les incertitudes du modèle $\varepsilon(t)$ et les bruits de mesure $\eta(t)$. Le modèle modifié peut s'écrire :

$$\begin{cases} \dot{x}(t) = A(t)x(t) + Bu(t) + \epsilon(t) \\ x(t) = \begin{bmatrix} L_d i_d(t) + \sqrt{\frac{3}{2}}\Phi \\ f(i_d(t)) \end{bmatrix} + \eta(t) \end{cases}$$

Ainsi, il est possible d'obtenir un modèle plus réaliste du flux magnétique.

Ensuite, on discrétise ce modèle pour l'application du filtre de Kalman. Pour cela, on considère une période d'échantillonnage $T_s$. On peut alors écrire les équations suivantes :

$$\begin{cases} x(k) = A_d(k-1)x(k-1) + B_d(k-1)u(k-1) + B_d(k-1)\epsilon(k-1) \\ x(k) = \begin{bmatrix} L_d i_d(k) + \sqrt{\frac{3}{2}}\Phi \\ f(i_d(k)) \end{bmatrix} + \eta(k) \end{cases}$$

avec

$$\begin{cases} A_d(k-1) = e^{T_s A(t)}, \\ B_d(k-1) = \int_0^{T_s} e^{\tau A(\tau)} B d\tau \end{cases}$$

Etant donné que la matrice A est fonction de la vitesse, elle-même fonction du temps, il n'est pas possible de déterminer analytiquement les matrices $A_d$ et $B_d$.

Selon un aspect de ce mode de réalisation, les matrices $A_d$ et $B_d$ peuvent être obtenues par un développement en série de Taylor. De préférence, afin d'être performant, on peut déterminer les matrices $A_d$ et $B_d$ par un développement en série de Taylor d'ordre 3. Dans ce cas, les matrices $A_d$ et $B_d$ peuvent s'écrire :

$$A_d = \begin{bmatrix} 1 & 0 \\ 0 & 1 \end{bmatrix} + T_s \begin{bmatrix} 0 & \omega_e \\ -\omega_e & 0 \end{bmatrix} + \frac{T_s^2}{2} \begin{bmatrix} 0 & \omega_e \\ -\omega_e & 0 \end{bmatrix}^2 + \frac{T_s^3}{6} \begin{bmatrix} 0 & \omega_e \\ -\omega_e & 0 \end{bmatrix}^3,$$

$$B_d = T_s \begin{bmatrix} 1 & 0 \\ 0 & 1 \end{bmatrix} + \frac{T_s^2}{2} \begin{bmatrix} 0 & \omega_e \\ -\omega_e & 0 \end{bmatrix} + \frac{T_s^3}{6} \begin{bmatrix} 0 & \omega_e \\ -\omega_e & 0 \end{bmatrix}^2 + \frac{T_s^4}{24} \begin{bmatrix} 0 & \omega_e \\ -\omega_e & 0 \end{bmatrix}^3$$

Enfin, on applique un algorithme de filtre de Kalman adaptatif.

Par la suite, on pose :

$$\zeta(k) = B_d \epsilon(k).$$

Une possibilité pour déterminer le vecteur d'état inconnu x, est de prendre en compte les informations $\zeta(k)$ et $\eta(k)$ dans le filtre de Kalman adaptatif. De manière pratique, ce filtre de Kalman adaptatif apporte une solution au problème de minimisation décrit ci-dessous :

$$\min_{x(k)} J(k)$$

avec

$$J(k) = (x(0) - \overline{x}(0))^T P_0^{-1} (x(0) - \overline{x}(0)) + \sum_{j=1}^{k} \left( \zeta(j-1)^T Q^{-1} \zeta(k-1) + \eta(j)^T R^{-1} \eta(j) \right)$$

$$\zeta(k-1) = x(k) - A_d(k-1)x(k-1) - B_d u(k-1)$$

$$\eta(k) = x(k) - \begin{bmatrix} L_d i_d(k) + \sqrt{\frac{3}{2}}\Phi \\ f(i_d(k)) \end{bmatrix}$$

La fonction de coût J donne un guide pour le choix des matrices $P_0$, R et Q, avec les conditions suivantes :

1. si l'état initial x(k) au temps k=0 est bien connu, c'est-à-dire $\overline{x}(0) \approx x(0)$, alors les valeurs de la matrice $P_0$ sont relativement faibles. Sinon les valeurs de la matrice $P_0$ sont relativement élevées.
2. s'il y a beaucoup de bruit de mesures, alors les valeurs de la matrice R sont relativement faibles. Sinon les valeurs de la matrice R sont relativement élevées.

De plus, Q peut être choisi en tant que :

$$Q = B_d Q_\epsilon B_d^T$$

avec $Q_\epsilon$ un paramètre d'ajustement. Cette relation implique que la matrice Q est fonction de la vitesse de rotation du rotor.

Dans le but de résoudre le problème de minimisation, en utilisant le filtre de Kalman adaptatif, on peut adopter les hypothèses ci-dessous. Ces hypothèses concernent principalement une interprétation mathématique des matrices $P_0$, R et Q.

- l'état initial x(0) est un vecteur aléatoire qui n'est pas corrélé avec les bruits $\zeta(k)$ et $\eta(k)$
- l'état initial x(0) a une moyenne connue $\overline{x}(0)$ et une covariance définie par

$$P_0 = E[(x(0) - \overline{x}(0))(x(0) - \overline{x}(0))^T]$$

où E désigne l'espérance.

- $\zeta(k)$ et $\eta(k)$ ne sont pas corrélés, et sont des bruits blancs de moyenne nulle avec des matrices de covariance Q et R, respectivement, en d'autres termes :

$$E[\zeta(k)\zeta(j)^T] = \begin{cases} Q, & \text{if} \quad k = j, \\ 0, & \text{if} \quad k \neq j \end{cases}$$

$$E[\eta(k)\eta(j)^T] = \begin{cases} R, & \text{if} \quad k = j, \\ 0, & \text{if} \quad k \neq j \end{cases}$$

$$E[\zeta(k)\eta(j)^T] = 0, \text{ for all } k, j$$

On peut noter que cette hypothèse implique également que Q et R sont des matrices semi-définies positives symétriques.

On adopte également les notations suivantes :

- $\hat{x}(k|k-1)$ est l'estimation de $x(k)$ à partir des mesures jusqu'au temps $k-1$, soit $x(k-1)$, $x(k-2)$, ... et $u(k-1)$, $u(k-2)$, ...
- $\hat{x}(k|k)$ est l'estimation de $x(k)$ à partir des mesures jusqu'au temps $k$, soit $x(k)$, $x(k-1)$, ... et $u(k)$, $u(k-1)$, ...
- $P(k|k-1)$ est la matrice de covariance de $x(k)$ étant donné $x(k-1)$, $x(k-2)$, ... et $u(k-1)$, $u(k-2)$, ...
- $P(k|k)$ est la matrice de covariance de $x(k)$ à partir des mesures jusqu'au temps $k$, soit $x(k)$, $x(k-1)$, ... et $u(k)$, $u(k-1)$, ...

Ensuite, l'algorithme de filtre de Kalman adaptatif peut être résumé de la manière suivante, avec une équation de mise à jour temporelle :

$$\begin{cases} \hat{x}(k|k-1) &= A_d \hat{x}(k-1|k-1) + B_d u(k-1), \\ P(k|k-1) &= A_d P(k-1|k-1) A_d^T + B_d Q_\epsilon B_d^T \end{cases}$$

et une équation de mise à jour des mesures :

$$\begin{cases} K(k) &= P(k|k-1)(P(k|k-1)+R)^{-1} \\ \hat{x}(k|k) &= \hat{x}(k|k-1) + K(k)(x(k) - \hat{x}(k|k-1)) \\ P(k|k) &= (I - K(k))P(k|k-1) \end{cases}$$

Ainsi, le flux magnétique de la machine électrique peut être déterminé.

Selon une mise en œuvre de l'invention, l'approche du filtre de Kalman adaptatif peut être résumée de la manière suivante :

1. On utilise les entrées estimées au temps précédents listées ci-dessous, et les paramètres $Q_\varepsilon$ et R (matrices de covariance) et on détermine :

$$x(k) = \left[ \begin{array}{c} L_d i_d(k) + \sqrt{\frac{3}{2}}\Phi \\ f(i_d(k)) \end{array} \right]$$

$$u(k) = \left[ \begin{array}{c} v_d(t) - R(t)i_d(t) \\ v_q(t) - R(t)i_q(t) \end{array} \right]$$

$$\hat{x}(k-1|k-1)$$

$$P(k-1|k-1)$$

2. On détermine la sortie en mettant en œuvre les étapes suivantes

(1) On initialise $k = 0$, le vecteur d'état $\hat{x}(0)$ et l'état de la matrice de covariance, P(0|0) = $P_0$
(2) On applique les équations de mise à jour temporelle et de mise à jour de mesure pour obtenir $\hat{x}(k|k)$ et $P(k|k)$ :

$$\begin{cases} \hat{x}(k|k-1) & = A_d\hat{x}(k-1|k-1) + B_d u(k-1), \\ P(k|k-1) & = A_d P(k-1|k-1)A_d^T + B_d Q_\epsilon B_d^T \end{cases}$$

$$\begin{cases} K(k) & = P(k|k-1)\left(P(k|k-1) + R\right)^{-1} \\ \hat{x}(k|k) & = \hat{x}(k|k-1) + K(k)\left(x(k) - \hat{x}(k|k-1)\right), \\ P(k|k) & = \left(I - K(k)\right)P(k|k-1) \end{cases}$$

(3) On détermine le flux magnétique $\varphi$ estimé au temps k par les formules

$$\begin{cases} \hat{\varphi}_d(k) = \hat{x}_1(k|k), \\ \hat{\varphi}_q(k) = \hat{x}_2(k|k) \end{cases}$$

Dans ces équations, l'indice 1 désigne le premier terme du vecteur x, et l'indice 2 désigne le deuxième terme du vecteur x.

5) Contrôle de la machine électrique

Cette étape est facultative.
L'invention concerne également un procédé de contrôle, en temps réel, d'une machine électrique synchrone, pour lequel on réalise les étapes suivantes :

- on détermine le flux magnétique de la machine électrique à l'aide du procédé (étapes 1) à 4)) décrit ci-dessus ; et
- on contrôle le couple de ladite machine synchrone en fonction du flux magnétique déterminé. Pour cette étape, on peut utiliser tout moyen classique de contrôle de la machine électrique, qui prend en en compte le flux magnétique. Par exemple, le contrôle de la machine électrique peut être basée sur une méthode de contrôle direct du couple (en anglais « direct torque control method ») performante, et particulièrement adaptée pour les machines électriques synchrones à pôles saillants.

En outre, l'invention concerne un système de contrôle d'une machine électrique synchrone adapté à appliquer le procédé tel que décrit ci-dessus. Un tel système de contrôle de machine électrique peut comprendre des moyens de contrôle de la machine électrique comportant des moyens de détermination du flux magnétique de la machine électrique et des moyens de contrôle du couple de la machine électrique. Les moyens de détermination du flux magnétique déterminent le flux magnétique de la machine électrique à partir des mesures de courants et de tensions. Il s'agit des courants et des tensions de chacune des trois phases de la machine électrique. Les moyens de contrôle du couple appliquent des tensions aux bornes de la machine électrique en fonction du flux magnétique afin d'assurer une consigne de couple pour la machine électrique. Avantageusement, le système de contrôle peut être un contrôleur comprenant des moyens informatiques.

Ce procédé et ce système de contrôle, peuvent être utilisés pour une machine électrique embarquée à bord d'un véhicule, notamment à bord d'un véhicule automobile électrique ou hybride. Toutefois, le système de commande décrit n'est pas limité à cette application et convient pour toutes les applications des machines électriques.

Selon un aspect, la machine électrique est une machine électrique synchrone à pôles saillants. En effet, le procédé est particulièrement adapté à ce type de machine, d'une part, car le modèle dynamique de la machine électrique est bien représentatif de ce type de machine électrique, et car la détermination du flux magnétique permet le contrôle d'une telle machine électrique, notamment par un contrôle direct du couple.

**Revendications**

1. Procédé de détermination du flux magnétique d'une machine électrique, ladite machine électrique comprenant un rotor, un stator, ledit stator comprenant des bobinages connectés à une pluralité de phases électriques, **caractérisé en ce qu'**on met en œuvre les étapes suivantes :

   a) On mesure (MES) un courant et une tension dans lesdites phases de ladite machine électrique ;
   b) On détermine la vitesse de rotation électrique (VIT) dudit rotor, notamment en fonction de la vitesse de rotation mécanique dudit rotor ;
   c) On construit un modèle dynamique dudit flux magnétique de ladite machine électrique (MOD), ledit modèle dynamique dudit flux magnétique reliant ledit flux magnétique au courant et à la tension des phases de la machine électrique, et à ladite vitesse de rotation électrique dudit rotor ; et
   d) On détermine ledit flux magnétique $\varphi$ en appliquant un filtre de Kalman adaptatif (KAL) audit modèle dynamique de flux magnétique (MOD), ledit modèle dynamique de flux magnétique (MOD) étant appliqué auxdites mesures de courant et de tension (MES) et à ladite vitesse de rotation électrique (VIT) déterminée, **caractérisé en ce que** ledit filtre de Kalman adaptatif étant appliqué en mettant en œuvre les étapes suivantes :

      i) On modifie ledit modèle dynamique de flux magnétique en intégrant des incertitudes dans ledit modèle et un bruit de mesure ;
      ii) On discrétise ledit modèle dynamique de flux magnétique modifié ; et
      iii) On applique un algorithme de filtre de Kalman adaptatif audit modèle modifié et discrétisé, en mettant en œuvre les étapes suivantes :

         (1) On initialise k = 0, le vecteur d'état x̂(0) et l'état de la matrice de covariance,

$$P(0|0) = P_0$$

         (2) On applique les équations de mise à jour temporelle et de mise à jour de mesure pour obtenir $\hat{x}(k|k)$ et $P(k|k)$ :

$$\begin{cases} \hat{x}(k|k-1) & = A_d\hat{x}(k-1|k-1) + B_d u(k-1), \\ P(k|k-1) & = A_d P(k-1|k-1)A_d^T + B_d Q_\epsilon B_d^T \end{cases}$$

$$
\begin{cases}
K(k) & = P(k|k-1)\,(P(k|k-1)+R)^{-1} \\
\hat{x}(k|k) & = \hat{x}(k|k-1) + K(k)\,(x(k) - \hat{x}(k|k-1)), \\
P(k|k) & = (I - K(k))\,P(k|k-1)
\end{cases}
$$

(3) On détermine ledit flux magnétique $\varphi$ estimé au temps k par les formules

$$
\begin{cases}
\hat{\varphi}_d(k) = \hat{x}_1(k|k), \\
\hat{\varphi}_q(k) = \hat{x}_2(k|k)
\end{cases}
$$

Avec k le temps discrétisé, A_d,B_d, des matrices de la réalisation d'état, P la matrice de covariance du vecteur d'état, R une matrice de calibration, K le gain du filtre de Kalman, Q_$\varepsilon$ un paramètre d'ajustement.

**2.** Procédé de détermination du flux magnétique selon la revendication 1, dans lequel on détermine ladite vitesse de rotation électrique $\omega_e$ dudit rotor par une formule du type $\omega_e = p\omega$ avec p le nombre de paires de pôles de la machine électrique et $\omega$ la vitesse de rotation mécanique dudit rotor.

**3.** Procédé de détermination du flux magnétique selon la revendication 2, dans lequel on détermine ladite vitesse de rotation mécanique par une méthode de boucle à phase asservie PLL.

**4.** Procédé de détermination du flux magnétique selon l'une des revendications précédentes, dans lequel ledit modèle dynamique de flux magnétique (MOD) s'écrit

$$
\begin{cases}
\varphi_d(t) = L_d i_d(t) + \sqrt{\tfrac{3}{2}}\Phi, \\
\varphi_q(t) = \begin{cases}
L_{qs} i_q(t) - b_{qs}, & \text{if } i_q(t) \leq -i_{qm}, \\
L_q i_q(t), & \text{if } -i_{qm} \leq i_q(t) \leq i_{qm}, \\
L_{qs} i_q(t) + b_{qs} & \text{if } i_{qm} \leq i_q(t)
\end{cases}
\end{cases}
$$

avec $\varphi$ le flux magnétique de la machine électrique, i le courant, $\Phi$ le flux du rotor, L les inductances de ladite machine électrique, $L_{qs}$, $b_{qs}$ des coefficients qui prennent en compte l'effet de saturation, d et q les axes dans le repère de Park, et $i_{qm}$ la valeur de courant de quadrature pour lequel le flux magnétique est une fonction linéaire du courant de quadrature.

**5.** Procédé de détermination du flux magnétique selon l'une des revendications précédentes, dans lequel ladite machine électrique est une machine électrique synchrone à pôles saillants.

**6.** Procédé de contrôle d'une machine électrique, dans lequel met en œuvre les étapes suivantes :

a) On détermine un flux magnétique $\varphi$ de ladite machine électrique au moyen du procédé de détermination dudit flux magnétique selon l'une des revendications précédentes ; et
b) On contrôle (CON) ladite machine électrique au moyen dudit flux magnétique déterminé.

**7.** Procédé de contrôle selon la revendication 6, dans lequel on contrôle ladite machine électrique (CON) selon une méthode de contrôle direct du couple de la machine électrique mise en œuvre à partir dudit flux magnétique.

**8.** Système de contrôle d'une machine électrique, ladite machine électrique comprenant un rotor, un stator, ledit stator comprenant des bobinages connectés à une pluralité de phases électriques, ledit système de contrôle comprenant des capteurs de tension et de courant, des moyens de détermination de la vitesse du rotor, et moyens de contrôle pour mettre en œuvre le procédé de contrôle selon l'une des revendications 6 ou 7.

**Patentansprüche**

1. Verfahren zur Bestimmung des magnetischen Flusses einer elektrischen Maschine, wobei die elektrische Maschine einen Rotor, einen Stator umfasst, wobei der Stator Wicklungen umfasst, die an eine Mehrzahl von elektrischen Phasen angeschlossen sind, **dadurch gekennzeichnet, dass** man die folgenden Schritte durchführt:

   a) Man misst (MES) einen Strom und eine Spannung in den Phasen der elektrischen Maschine;
   b) Man bestimmt die elektrische Drehzahl (VIT) des Rotors, insbesondere in Abhängigkeit von der mechanischen Drehzahl des Rotors;
   c) Man erstellt ein dynamisches Modell des magnetischen Flusses der elektrischen Maschine (MOD), wobei das dynamische Modell des magnetischen Flusses den magnetischen Fluss mit dem Strom und mit der Spannung der Phasen der elektrischen Maschine und mit der elektrischen Drehzahl des Rotors verknüpft; und
   d) Man bestimmt den magnetischen Fluss $\varphi$, indem man ein adaptives Kalman-Filter (KAL) auf das dynamische Modell des magnetischen Flusses (MOD) anwendet, wobei das dynamische Modell des magnetischen Flusses (MOD) auf die Strom- und Spannungsmessungen (MES) und auf die bestimmte elektrische Drehzahl (VIT) angewandt wird, **dadurch gekennzeichnet, dass** das adaptive Kalman-Filter angewandt wird, indem die folgenden Schritte durchgeführt werden:

   i) Man ändert das dynamische Modell des magnetischen Flusses, indem man Unsicherheiten und ein Messrauschen in das Modell einbezieht;
   ii) Man diskretisiert das geänderte Modell des dynamischen Flusses; und
   iii) Man wendet einen Algorithmus eines adaptiven Kalman-Filters auf das geänderte und diskretisierte Modell an, indem die folgenden Schritte durchgeführt werden:

   (1) Man initialisiert k = 0, den Zustandsvektor $\hat{x}(0)$ und den Zustand der Kovarianzmatrix, $P(0|0) = P_0$
   (2) Man wendet die Zeitaktualisierungs- und Messaktualisierungsgleichungen an, um $\hat{x}(k|k)$ *und* $P(k|k)$ zu erhalten:

$$\begin{cases} \hat{x}(k|k-1) & = A_d\hat{x}(k-1|k-1) + B_d u(k-1), \\ P(k|k-1) & = A_d P(k-1|k-1)A_d^T + B_d Q_\epsilon B_d^T \end{cases}$$

$$\begin{cases} K(k) & = P(k|k-1)\left(P(k|k-1) + R\right)^{-1} \\ \hat{x}(k|k) & = \hat{x}(k|k-1) + K(k)\left(x(k) - \hat{x}(k|k-1)\right), \\ P(k|k) & = \left(I - K(k)\right)P(k|k-1) \end{cases}$$

   (3) Man bestimmt den geschätzten magnetischen Flusses $\varphi$ zur Zeit k durch die Formeln

$$\begin{cases} \hat{\varphi}_d(k) = \hat{x}_1(k|k), \\ \hat{\varphi}_q(k) = \hat{x}_2(k|k) \end{cases}$$

   Worin k die diskretisierte Zeit ist, A_d,B_d, Matrizen der Zustandsrealisierung sind, P die Kovarianzmatrix des Zustandsvektors ist, R eine Kalibrierungsmatrix ist, K die Verstärkung des Kalman-Filters ist, Q_$\varepsilon$ ein Anpassungsparameter ist.

2. Verfahren zur Bestimmung des magnetischen Flusses nach Anspruch 1, bei dem man die elektrische Drehzahl $\omega_e$ des Rotors durch eine Formel des Typs $\omega_e = \rho\omega$ bestimmt, wobei p die Polpaarzahl der elektrischen Maschine ist und $\omega$ die mechanische Drehzahl des Rotors ist.

3. Verfahren zur Bestimmung des magnetischen Flusses nach Anspruch 2, bei dem man die mechanische Drehzahl durch eine Methode mit Phasenregelschleife PLL bestimmt.

4. Verfahren zur Bestimmung des magnetischen Flusses nach einem der vorhergehenden Ansprüche, bei dem das dynamische Modell des magnetischen Flusses (MOD) geschrieben wird als

$$\begin{cases} \varphi_d(t) = L_d i_d(t) + \sqrt{\frac{3}{2}}\Phi, \\ \varphi_q(t) = \begin{cases} L_{qs}i_q(t) - b_{qs}, & \text{if } i_q(t) \leq -i_{qm}, \\ L_q i_q(t), & \text{if } -i_{qm} \leq i_q(t) \leq i_{qm}, \\ L_{qs}i_q(t) + b_{qs} & \text{if } i_{qm} \leq i_q(t) \end{cases} \end{cases}$$

wobei $\varphi$ der magnetische Fluss der elektrischen Maschine ist, i der Strom ist, $\Phi$ der Fluss des Rotors ist, L die Induktivitäten der elektrischen Maschine sind, $L_{qs}$, $b_{qs}$ den Sättigungseffekt berücksichtigende Koeffizienten sind, d und q die Achsen in dem Park-Koordinatensystem sind und $i_{qm}$ der Wert des Quadraturstroms ist, bei dem der magnetische Fluss eine lineare Funktion des Quadraturstroms ist.

5. Verfahren zur Bestimmung des magnetischen Flusses nach einem der vorhergehenden Ansprüche, bei dem die elektrische Maschine eine elektrische Schenkelpolsynchronmaschine ist.

6. Verfahren zur Steuerung einer elektrischen Maschine, bei dem man die folgenden Schritte durchführt:

   a) Man bestimmt einen magnetischen Fluss $\varphi$ der elektrischen Maschine mittels des Verfahrens zur Bestimmung des magnetischen Flusses nach einem der vorhergehenden Ansprüche; und
   b) Man steuert (CON) die elektrische Maschine mittels des bestimmten magnetischen Flusses.

7. Verfahren zur Steuerung nach Anspruch 6, bei dem man die elektrische Maschine (CON) nach einer Methode zur direkten Steuerung des Drehmoments der elektrischen Maschine steuert, die ausgehend von dem magnetischen Fluss durchgeführt wird.

8. System zur Steuerung einer elektrischen Maschine, wobei die elektrische Maschine einen Rotor, einen Stator umfasst, wobei der Stator Wicklungen umfasst, die an eine Mehrzahl von elektrischen Phasen angeschlossen sind, wobei das System zur Steuerung Spanungs- und Stromsensoren, Mittel zur Bestimmung der Drehzahl des Rotors und Steuerungsmittel zur Durchführung des Verfahrens zur Steuerung nach einem der Ansprüche 6 oder 7 umfasst.

**Claims**

1. Method for determining the magnetic flux of an electric machine, said electric machine comprising a rotor and a stator, said stator comprising windings connected to a plurality of electric phases, **characterized in that** the following steps are implemented:

   a) a current and a voltage in said phases of said electric machine are measured (MES);
   b) the electrical rotation speed (VIT) of said rotor is determined, notably as a function of the mechanical rotation speed of said rotor;
   c) a dynamic model (MOD) of said magnetic flux of said electric machine is constructed, said dynamic model of said magnetic flux connecting said magnetic flux to the current and to the voltage of the phases of the electric machine and to said electrical rotation speed of said rotor; and
   d) said magnetic flux $\varphi$ is determined by applying an adaptive Kalman filter (KAL) to said dynamic magnetic flux model (MOD), said dynamic magnetic flux model (MOD) being applied to said current and voltage measurements (MES) and to said determined electrical rotation speed (VIT), **characterized in that** said adaptive Kalman filter is applied by implementing the following steps:

      i) said dynamic magnetic flux model is modified by integrating uncertainties into said model and measurement noise;
      ii) said modified dynamic magnetic flux model is discretized; and
      iii) an adaptive Kalman filter algorithm is applied to said modified and discretized model, by implementing the following steps:

(1) $k = 0$, the state vector $\hat{x}(0)$ and the state of the covariance matrix, $P(0|0) = P_0$, are initialized,
(2) the time update and measurement update equations are applied in order to obtain $\hat{x}(k|k)$ *and* $P(k|k)$:

$$\begin{cases} \hat{x}(k|k-1) & = A_d\hat{x}(k-1|k-1) + B_du(k-1), \\ P(k|k-1) & = A_dP(k-1|k-1)A_d^T + B_dQ_\epsilon B_d^T \end{cases}$$

$$\begin{cases} K(k) & = P(k|k-1)\left(P(k|k-1) + R\right)^{-1} \\ \hat{x}(k|k) & = \hat{x}(k|k-1) + K(k)\left(x(k) - \hat{x}(k|k-1)\right), \\ P(k|k) & = (I - K(k))P(k|k-1) \end{cases}$$

(3) said magnetic flux $\varphi$ estimated at the time k is determined by the formulae

$$\begin{cases} \hat{\varphi}_d(k) = \hat{x}_1(k|k), \\ \hat{\varphi}_q(k) = \hat{x}_2(k|k) \end{cases}$$

with k being the discretized time, A_d, B_d matrices of the state description, P the covariance matrix of the state vector, R a calibration matrix, K the gain of the Kalman filter and Q_ε an adjustment parameter.

2. Method for determining the magnetic flux according to Claim 1, wherein said electrical rotation speed $\omega_e$ of said rotor is determined by means of a formula of the type $\omega_e = \rho\omega$ with p being the number of pole pairs of the electric machine and $\omega$ the mechanical rotation speed of said rotor.

3. Method for determining the magnetic flux according to Claim 2, wherein said mechanical rotation speed is determined by means of a phase-locked loop, PLL, method.

4. Method for determining the magnetic flux according to one of the preceding claims, wherein said dynamic magnetic flux model (MOD) is written

$$\begin{cases} \varphi_d(t) = L_d i_d(t) + \sqrt{\tfrac{3}{2}}\Phi, \\ \varphi_q(t) = \begin{cases} L_{qs}i_q(t) - b_{qs}, & \text{if } i_q(t) \leq -i_{qm}, \\ L_q i_q(t), & \text{if } -i_{qm} \leq i_q(t) \leq i_{qm}, \\ L_{qs}i_q(t) + b_{qs} & \text{if } i_{qm} \leq i_q(t) \end{cases} \end{cases}$$

with $\varphi$ being the magnetic flux of the electric machine, i the current, $\Phi$ the flux of the rotor, L the inductances of said electric machine, $L_{qs}$ and $b_{qs}$ coefficients which take into account the saturation effect, d and q the axes in the Park reference system and $i_{qm}$ the quadrature current value for which the magnetic flux is a linear function of the quadrature current.

5. Method for determining the magnetic flux according to one of the preceding claims, wherein said electric machine is a salient pole synchronous electric machine.

6. Method for controlling an electric machine, wherein the following steps are implemented:

a) a magnetic flux $\varphi$ of said electric machine is determined by means of the method for determining said magnetic flux according to one of the preceding claims; and
b) said electric machine is controlled (CON) by means of said determined magnetic flux.

7. Control method according to Claim 6, wherein said electric machine is controlled (CON) according to a method for directly controlling the torque of the electric machine implemented on the basis of said magnetic flux.

8. System for controlling an electric machine, said electric machine comprising a rotor and a stator, said stator comprising windings connected to a plurality of electric phases, said control system comprising voltage and current sensors, means for determining the speed of the rotor and control means for implementing the control method according to one of Claims 6 and 7.

**Figure 1**

**Figure 2**

**Figure 3**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2016254771 A1
- EP 2582036 A2
- EP 1885054 A1
- FR 3035755
- FR 2984637

**Littérature non-brevet citée dans la description**

- In: Renewable Energies for Developing Countries (REDEC). 2016 3rd International Conference on. IEEE, 2016, 1-6